Europäisches Patentamt

European Patent Office

Office européen des brevets

(11) Publication number: **0 293 216**
**A2**

## (12) EUROPEAN PATENT APPLICATION

(21) Application number: **88304816.7**

(22) Date of filing: **27.05.88**

(51) Int. Cl.4: **H 01 L 31/18**

(30) Priority: **27.05.87 GB 8712450**

(43) Date of publication of application:
**30.11.88 Bulletin 88/48**

(84) Designated Contracting States: **DE ES FR IT NL**

(71) Applicant: **THE MARCONI COMPANY LIMITED**
**The Grove Warren Lane**
**Stanmore Middlesex HA7 4LY (GB)**

(72) Inventor: **Singh, Surendra Pratap**
**1 Kestrel Avenue Moormede Park**
**Staines Middlesex, TW18 4RU (GB)**

(74) Representative: **Keppler, William Patrick**
**Central Patent Department Wembley Office The General**
**Electric Company, p.l.c. Hirst Research Centre East Lane**
**Wembley Middlesex HA9 7PP (GB)**

(54) Manufacture of infra-red detectors.

(57) A method of making cadmium mercury telluride infra-red detectors according to which a wafer of CMT mounted on a substrate is masked and etched to divide it into an array of detector elements. The array and substrate are then masked and metallized, and the mask is removed to leave a pattern of contacts and electrodes to each detector element.

In an alternative method, the electrodes are first formed on the substrate, then the CMT wafer is mounted on the substrate and, by masking and etching, divided into elements. Finally, metal contacts are formed to connect each element to its respective electrodes.

Fig.6.

## Description

### Manufacture of Infra-red Detectors

This invention relates to methods of manufacture of infra-red detectors and in particular to detectors made from cadmium mercury telluride.

The detectors with which this invention is concerned consist of a wafer of photosensitive material such as cadmium mercury telluride (CMT) mounted on an insulating substrate, typically sapphire, and divided up to form an array of detector elements. Each element is connected to a read-out electrode via a metal contact.

One suitable method of production of the photosensitive CMT wafer is described in our UK patent specification 2165089 which is herein incorporated by reference. The present invention relates to the further processing steps of mounting the wafer on a substrate, and defining the individual elements and the electrode pattern.

US Patent No.3977018 describes one possible procedure for this further processing in which the wafer of CMT is mounted on a sapphire substrate and coated with a layer of photoresist material. This layer is masked and developed to define the elements of the detector array. The elements are etched out by a bromine methanol spray etch. The remaining photoresist is then removed by spraying with a suitable solvent. Metal contacts to the elements are formed by coating their surfaces with positive photoresist, masking and developing to give openings in the resist for the contacts. Metal is evaporated onto the surface so that the openings are metallised. Excess metal on the photoresist is removed by dissolving in acetone.

European Patent No. 7668 describes a method in which the CMT wafer is attached to a sapphire substrate and coated with a layer of photoresist which extends over the wafer and the substrate. The layer is masked and developed to form a stripe mask across the wafer which defines what will be the active areas of the array. The wafer, substrate and mask are then metallised, and the masking stripe removed by dissolving in acetone to leave metal deposited over the wafer and substrate, except along a central stripe on the CMT wafer. A second masking layer of photoresist is then deposited and developed to leave a plurality of mask stripes running transverse to the previous stripe across the CMT wafer and the substrate. The exposed parts of the metallized substrate and the CMT wafer between the stripes are etched by ion-beam milling. The second masking layer is then removed, leaving an array of separate CMT detector elements and metal electrodes extending from each element.

An object of this invention is to provide an alternative method of manufacture to those described above and other known methods.

According to one aspect of the invention, a method of forming an infra-red detector array comprises the steps of:-

(i) attaching a body of infra-red sensitive material to an insulating substrate, (ii) forming an etchant masking layer on the body to mask portions of the body required to constitute elements of the array and etching to remove the remaining portions of the body, and (iii) forming a metallisation masking layer to mask sensing areas of the elements and metallising to provide metal contacts on the elements and electrodes on the substrate continuous with the metal contacts.

The step of forming a metallisation masking layer may comprise forming the metal contacts and the electrodes as parts of a continuous metallisation layer, the method comprising the further step of forming an etchant mask over the continuous metallisation layer to mask the metal contacts and the electrodes and etching to remove the remaining portions of the continuous metallisation layer.

The step of forming a metallisation masking layer may provide a masking layer which masks areas which isolate each element, its metal contacts and its electrodes from adjacent elements, metal contacts and electrodes, metallisation of the mask and the substrate providing each element with respective metal contacts and electrodes, and removal of the mask removing metallisation from the isolating areas.

According to another aspect of the invention a method of manufacturing an infra-red detector array comprises the steps of:-

i) attaching a body of infra-red sensitive material to an insulating substrate;

ii) forming a first masking layer as an etchant mask on said body and etching to divide the body into elements of said array;

iii) forming a second masking layer as a metallisation mask on the body and metallising the body, the substrate and said second masking layer;

iv) removing said second masking layer to lift off the metal thereon, thereby defining unmetallised sensing areas and metal contacts on said elements; and

v) forming a third masking layer as an etchant mask over said substrate and ion-etching the metal on said substrate to define electrodes connected to said contacts for each of said elements.

According to another aspect of the invention a method of manufacturing an infra-red detector array comprises the steps of:-

i) attaching a body of infra-red sensitive material to an insulating substrate;

ii) forming a first masking layer as an etchant mask on said body and etching to divide the body into elements of said array;

iii) forming a second masking layer as a metallisation mask on the body and metallising the body, the substrate and said second masking layer; and

iv) removing said second masking layer to lift off the metal thereon, thereby defining unmetallised sensing areas on each of said element, metal electrodes and metal contacts connecting said electrodes to respective elements.

According to a third aspect of the invention a method of manufacturing an infra-red detector array comprises the steps of:-

i) forming a first masking layer as a metallisation mask on an insulating substrate, and metallising the masked and unmasked areas of said substrate;

ii) removing said first masking layer to lift off the metal thereon, thereby defining metal electrodes for each of said elements;

iii) attaching a body of infra-red sensitive material to said substrate;

iv) forming a second masking layer as an etchant mask over said body;

v) etching to divide said body into the elements of the array;

vi) forming a third masking layer as a metallisation mask over said body and substrate, and metallising the masked and unmasked areas;
and

vii) removing said third masking layer to lift off the metal thereon, thereby defining on each of said elements unmetallised sensing areas and metal contacts connected to said metal electrodes.

Embodiments of the invention will now be described, by way of example, with reference to the accompanying drawings, of which:-

Figure 1 shows a wafer of CMT mounted on a substrate and covered by a first masking layer;

Figure 2 shows the wafer divided into elements and covered by a second masking layer;

Figure 3 shows a finished detector array made according to one aspect of the invention;

Figure 4 shows the wafer of Figure 1 divided into elements and covered by a second masking layer;

Figure 5 shows an electrode pattern deposited on a substrate;

Figure 6 shows a CMT wafer mounted over the electrode pattern and covered with an etchant mask, and

Figure 7 shows the wafer of Figure 6 divided into elements and covered by a metallisation mask.

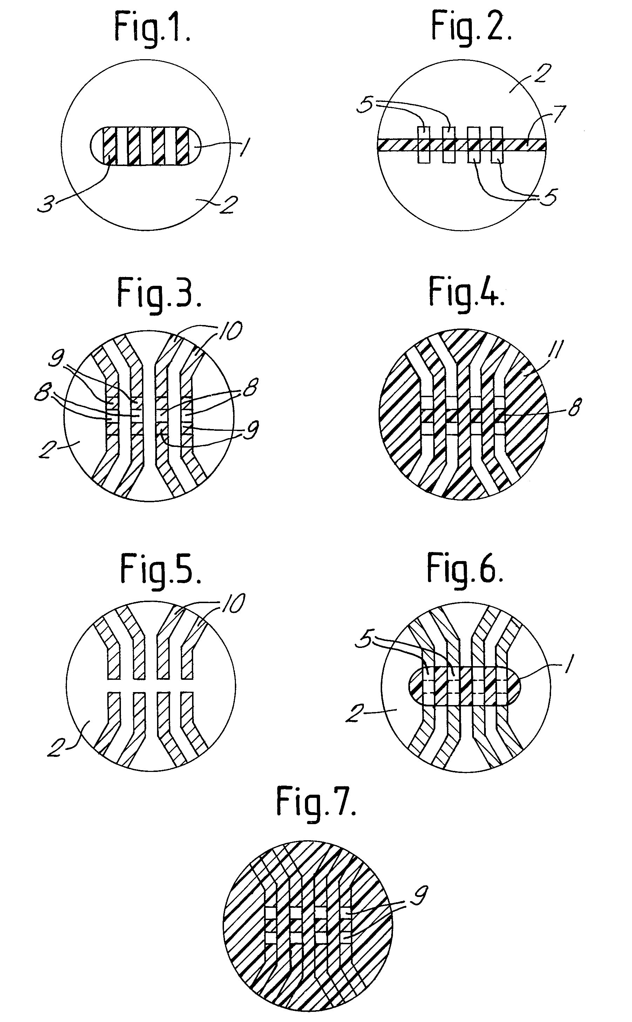

Referring first to Figures 1, 2 and 3 which relate to a first method of manufacture, a wafer 1 of photosensitive semiconducting CMT is shaped and mounted on a sapphire substrate 2 by known techniques. One such technique is described in our above-mentioned UK patent No.2165089 and, briefly, involves epitaxially growing a sheet of CMT on a suitable substrate such as CdTe, removing the substrate by chemical etching and passivating the CMT surfaces by anodisation. The sheet is then divided into individual wafers, typically about 2.6mm x 0.6mm, each wafer then being attached to a respective substrate. Each wafer 1 is polished down to a thickness of 5-20 um, then anodised to improve the surface quality.

A first masking layer 3 is formed on the wafer only, by depositing a coating of photoresist and masking and developing it. The developed mask defines individual elements 5 on the wafer, masking them so that, when etching of the surface is performed using a beam of argon ions, the elements 5 are formed by etching away the areas in between. The remaining photoresist is removed by washing in a suitable solvent.

Referring to Figure 2, a second masking layer 7 is formed over the detector elements, in the shape of a stripe. This mask 7 covers what will be the sensing area 8 of each detector element. The whole area of the substrate and detectors array is then metallised, by sputtering a deposit of chromium/gold. A lift-off process removes the masking strip 7 and the metal covering it, leaving an exposed central area 8 of passivated unmetallised CMT on each element 5.

Finally, a third photoresist mask, covering the electrodes and the elements 5, is developed on the metal layer and the unmasked metal is etched away by ion-etching, to form electrodes 10. At this stage, no etching of the CMT elements takes place. Accurate alignment of this third mask with the elements is therefore essential. The metal remaining on each detector element, either side of the sensing area 8, forms a contact 9, connecting the adjacent electrode to the CMT sensing area. The device after this final etch is shown in Figure 3.

The second and third masking steps, defining respectively the sensing areas and the electrode pattern, can be combined. Figure 4 shows a photoresist masking layer 11 developed over what will be the sensing areas 8, and over the substrate, exposing the electrode pattern. A Cr/Au layer is deposited by sputtering over the entire surface, then the mask 11 is removed, lifting-off the metal deposited on it and leaving a pattern of electrodes and contacts as shown in Figure 3.

Figures 5 - 7 show an alternative processing in which the electrodes are defined first and the detector elements last. A photoresist mask is deposited and developed on the sapphire substrate, to cover the whole surface except the CMT contact areas 9 and the electrode areas 10. The whole surface is then metallised with a Cr/Au layer. A lift-off process removes the mask with its metal coating, leaving the electrode pattern shown in Figure 5. This step could also be done by metallising the unmasked substrate surface, then depositing an etchant mask and etching away the metal between the electrodes.

A wafer 1 of CMT is then attached to the substrate, over the metal electrode pattern, see Figure 6, so as to bridge the gaps between the electrodes of each pair. An etchant mask is deposited over the wafer, in accurate alignment with the electrodes. Using an ion-beam, the CMT wafer is divided into a group of separate detector elements 5.

The final step, shown in Figure 7, is to form contacts 9 by suitably masking, then metallising the ends of the elements 5, the metallising extending over the ends of the element and on to the electrode strips to make the connection between the two. The mask is then dissolved off to leave the finished array of elements.

## Claims

1. A method of forming an infra-red detector array comprising the steps of:-

(i) attaching a body of infra-red sensitive material to an insulating substrate,

(ii) forming an etchant masking layer on said body to mask portions of said body required to constitute elements of said array and etching to remove the remaining portions of said body,

(iii) and forming a metallisation masking layer to mask sensing areas of said elements and metallising to provide metal contacts on said elements and electrodes on said substrate continuous with said metal contacts.

2. A method according to Claim 1, wherein said step of forming a metallisation masking layer comprises forming said metal contacts and said electrodes as parts of a continuous metallisation layer, the method comprising the further step of forming an etchant mask over said continuous metallisation layer to mask said metal contacts and said electrodes and etching to remove the remaining portions of said continuous metallisation layer.

3. A method according to Claim 1, wherein said step of forming a metallisation masking layer provides a masking layer which masks areas which isolate each element, its metal contacts and its electrodes from adjacent elements, metal contacts and electrodes, metallisation of the mask and said substrate providing each said element with respective metal contacts and electrodes, and removal of said mask removing metallisation from said isolating areas.

4. A method of forming an infra-red detector array comprising the steps of:-

(i) attaching a body of infra-red sensitive material to an insulating substrate;

(ii) forming a first masking layer as an etchant mask on said body and etching to divide the body into elements of said array;

(iii) forming a second masking layer as a metallisation mask on the body and metallising the body, the substrate and said second masking layer;

(iv) removing said second masking layer to lift off the metal thereon, thereby defining unmetallised sensing areas and metal contacts on said elements;

(v) forming a third masking layer as an etchant mask over said substrate and ion-etching the metal on said substrate to define electrodes connected to said contacts for each of said elements.

5. A method of forming an infra-red detector array comprising the steps of:-

(i) attaching a body of infra-red sensitive material to an insulating substrate;

(ii) forming a first masking layer as an etchant mask on said body and etching to divide the body into elements of said array;

(iii) forming a second masking layer as a metallisation mask on the body and metallising the body, the substrate and said second masking layer;

(iv) removing said second masking layer to lift off the metal thereon, thereby defining unmetallised sensing areas on each of said element, metal electrodes and metal contacts connecting said electrodes to respective elements.

6. A method of forming an array of infra-red detector elements comprising the steps of:-

(i) forming a first masking layer as a metallisation mask on an insulating substrate, and metallising the masked and unmasked areas of said substrate;

(ii) removing said first masking layer to lift off the metal thereon, thereby defining metal electrodes for each of said elements;

(iii) attaching a body of infra-red sensitive material to said substrate;

(iv) forming a second masking layer as an etchant mask over said body;

(v) etching to divide said body into the elements of the array;

(vi) forming a third masking layer as a metallisation mask over said body and substrate, and metallising the masked and unmasked areas;

(vii) removing said third masking layer to lift off the metal thereon, thereby defining on each of said elements unmetallised sensing areas and metal contacts connected to said metal electrodes.

7. An infra-red detector array formed by a method according to any preceding claim.

14 07 88

0293216

## Fig.1.

## Fig.2.

## Fig.3.

## Fig.4.

## Fig.5.

## Fig.6.

## Fig.7.